# EUROPÄISCHE PATENTSCHRIFT

(11) **EP 1 514 304 B1**
(45) Veröffentlichungstag und Bekanntmachung des Hinweises auf die Patenterteilung: **21.11.2007**
(21) Anmeldenummer: 03740097.5
(22) Anmeldetag: 17.06.2003
(51) Int. Cl.: H01L 21/8247, H01L 21/336, H01L 27/115

(54) **VERFAHREN ZUR HERSTELLUNG EINER NROM-SPEICHERZELLENANORDNUNG**
METHOD FOR THE PRODUCTION OF AN NROM MEMORY CELL ARRANGEMENT
PROCEDE DE PRODUCTION D'UN SYSTEME DE CELLULES DE MEMOIRE NROM

(30) Priorität: 17.06.2002 DE 10226964
(43) Veröffentlichungstag der Anmeldung: 16.03.2005
(73) Patentinhaber: Qimonda AG, 81739 München (DE)
(72) Erfinder: DEPPE, Joachim, 01099 Dresden (DE); KLEINT, Christoph, 01129 Dresden (DE); LUDWIG, Christoph, 01465 Langebrück (DE)
(74) Vertreter: Epping - Hermann - Fischer
(86) Internationale Anmeldenummer: PCT/DE2003/002025
(87) Internationale Veröffentlichungsnummer: WO 2003/107416

(56) Entgegenhaltungen:
- WO-A-02/15276
- WO-A-02/15278
- DE-A- 10 129 958
- US-A- 5 071 782

## Beschreibung

Die Erfindung betrifft den Bereich der elektrisch beschreib- und löschbaren Non-volatile-Flash-Memories. Sie gibt ein Verfahren zur Herstellung eines NROM-Speichers mit einer Anordnung von mit einer Oxid-Nitrid-Oxid-Speicherschicht aufgebauten nichtflüchtigen Speicherzellen an, die in einer Virtual-Ground-NOR-Architektur eingesetzt werden kann.

Kleinste nichtflüchtige Speicherzellen werden für höchste Integrationsdichte bei Multimedia-Anwendungen benötigt. Die Weiterentwicklung der Halbleitertechnik ermöglicht zunehmend größere Speicherkapazitäten, die sehr bald den Gigabitbereich erschließen werden. Während jedoch die von der Lithographie bestimmte minimale Strukturgröße weiterhin abnimmt, können andere Parameter, wie z. B. die Dicke des Tunneloxids nicht mehr entsprechend skaliert werden. Die bei planaren Transistoren mit der Strukturverkleinerung einhergehende Abnahme der Kanallänge erfordert eine Erhöhung der Kanaldotierung, um das Auftreten eines als Punch-through bezeichneten Spannungsdurchbruchs zwischen Source und Drain zu vermeiden. Das führt zu einer Erhöhung der Einsatzspannung, die üblicherweise mit einer Reduktion der Dicke des Gateoxids kompensiert wird.

Durch Channel-hot-Electrons programmierbare, mit Hot-Holes löschbare planare SONOS-Speicherzellen (s. Boaz Eitan US 5,768,192, US 6,011,725, WO 99/60631) erfordern jedoch ein Steuer-Dielektrikum mit einer einem Gate-Oxid gleichwertigen Dicke. Diese Dicke kann aber nicht beliebig vermindert werden, ohne dass die Anzahl der ausführbaren Programmierzyklen ("Endurance" der Speicherzelle) in nicht zu tolerierender Weise abnimmt. Erforderlich ist deshalb eine hinreichend große Kanallänge, damit die Dotierstoffkonzentration im Kanal nicht zu hoch gewählt werden muss, weil sonst die Einsatzspannung zu sehr ansteigt.

In der WO 02/15276 A2 ist eine Speicherzellenanordnung beschrieben, bei der jede Speicherzelle eine in einem Graben zwischen einem Source-Bereich und einem Drain-Bereich angeordnete Gate-Elektrode aufweist. Die Gate-Elektrode ist von dem Halbleitermaterial durch dielektrisches Material getrennt. Zumindest zwischen dem Source-Bereich und der Gate-Elektrode und zwischen dem Drain-Bereich und der Gate-Elektrode ist eine Oxid-Nitrid-Oxid-Schichtfolge vorhanden, die für das Einfangen von Ladungsträgern an Source und Drain vorgesehen ist.

In der US 5,071,782 ist eine Speicherzellenanordnung beschrieben, bei der jede Speicherzelle eine Gate-Elektrode aufweist, die in einer quadratischen Aussparung des Halbleiterkörpers angeordnet ist. An der Oberseite des Halbleiterkörpers befinden sich zwischen den Gate-Elektroden Drain-Bereiche und zugehörige Bitleitungen und an den Böden der Aussparungen Source-Bereiche und zugehörige Sourceleitungen. Dazwischen befinden sich an den Wänden der Aussparungen die Kanalbereiche. Zwischen den Gate-Elektroden und dem Halbleitermaterial sind elektrisch isolierte Floating-Gate-Elektroden als Speichermedium angeordnet.

In der WO 02/15278 A3 ist ein Halbleiterbauelement mit einer mehrfachen Gate-Elektrode beschrieben. Das Speichermedium ist an Seitenwänden streifenförmiger Polysiliziumstrukturen angeordnet.

In der Veröffentlichung von J. Tanaka et al.: "A Sub-0.1-µm Grooved Gate MOSFET with High Immunity to Short-Channel Effects" in IEDM 93, S. 537 - 540 (1993) ist ein Transistor auf einem p⁺-Substrat beschrieben, bei dem die Gate-Elektrode in einem Graben zwischen dem n⁺-Source-Bereich und dem n⁺-Drain-Bereich angeordnet ist und so ein gekrümmter Kanal-Bereich in dem Substrat ausgebildet ist.

In der Veröffentlichung von K. Nakagawa et al.: "A Flash EE-PROM Cell with Self-Aligned Trench Transistor & Isolation Structure" in 2000 IEEE Symposium on VLSI Technology Digest of Technical Papers, seiten 124 - 125, ist ein Transistor als Speicherzelle mit einer Floating-gate-Elektrode beschrieben, die zwischen dem n⁺-Source-Bereich und dem n⁺-Drain-Bereich bis in eine p-Wanne des Substrates reichend angeordnet ist. Zwischen der Floating-gate-Elektrode und der Kontroll-gate-Elektrode befindet sich eine Dielektrikumschicht aus einer Oxid-Nitrid-Oxid-Schichtfolge.

In der DE 101 29 958 ist eine Speicherzellenanordnung beschrieben, die mit niederohmigen Bitleitungen versehen ist. Auf dotierten Source-/Drain-Bereichen von Speichertransistoren ist eine entsprechend den Bitleitungen streifenförmig strukturierte gesonderte Schicht oder Schichtfolge angeordnet, die, insbesondere als Metallisierung, elektrisch leitend mit den Source-/Drain-Bereichen verbunden ist und den ohmschen Widerstand der Bitleitungen reduziert. Diese Schicht oder Schichtfolge umfasst insbesondere mindestens ein Material aus der Gruppe von dotiertem Polysilizium, Wolfram, Wolframsilicid, Kobalt, Kobaltsilicid, Titan und Titansilicid.

Wenn die Source-/Drain-Bereiche in Silizium ausgebildet werden, kann die Metallisierung der Bitleitungen eine silizierte Metallschicht sein, die nach dem Verfahren hergestellt wird, das unter der Bezeichnung "Salicide" als Abkürzung von Self-Aligned-Silicide bekannt ist. Bei anderen Ausführungsformen, bevorzugt ebenfalls auf Silizium, ist eine als Metallisierung aufgebrachte Schichtfolge aus Polysilizium und WSi bzw. WN/W sowie eine abdeckende und elektrisch isolierende Schicht aus einem für eine Hartmaske geeigneten Material, zum Beispiel einem Oxid oder Nitrid, auf den Source-/Drain-Bereichen der Speichertransistoren vorhanden. Die Metallisierungen der Bitleitungsstrukturen sind direkt auf dem Substrat und nach Bedarf teilweise über oxidbedeckten Bereichen strukturiert.

Die Source-/Drain-Bereiche der einzelnen Speichertransistoren werden mit einer Source-/Drain-Implantation hoher Dosis oder durch eine Ausdiffusion von Dotierstoff aus einer geeigneten Schicht, z. B. aus Polysilizium, hergestellt. Mit den auf den Source-/Drain-Bereichen aufgebrachten streifenförmigen Metallisierungen sind die Bitleitungen gebildet, die wegen der guten Leitfähigkeit der Metallisierungen einen besonders niedrigen ohmschen Widerstand aufweisen. Unter einer Metallisierung ist hier eine metallhaltige Schicht oder eine zumindest metallartige Eigenschaften aufweisende Leiterbahn zu verstehen. Die Source-/Drain-Bereiche derselben Bitleitung brauchen nicht bereits im Halbleitermaterial elektrisch leitend miteinander verbunden zu sein. Vorzugsweise jedoch sind die Bitleitungen als vergrabene Bitleitungen mit streifenförmigen dotierten Bereichen im Halbleitermaterial ausgebildet, die zusätzlich mit den Metallisierungen versehen sind.

Die Bitleitungsstrukturen sind auf der von dem Halbleitermaterial abgewandten Oberseite vorzugsweise in Nitridschichten gekapselt, die als Streifen ausgeführt werden und im Herstellungsverfahren als Ätzmaske zur Erzeugung dazu selbstjustierter Kanalbereiche der Transistoren dienen. Nach dem Aufbringen einer Speicherschicht, die vorzugsweise eine aus einer Begrenzungsschicht, einer eigentlichen Speicherschicht und einer weiteren Begrenzungsschicht gebildeten Schichtfolge besteht, die nach Art einer ONO-Schicht ausgebildet ist, wird eine Schichtfolge zur Herstellung von Wortleitungen abgeschieden und vorzugsweise durch eine Trockenätzung streifenförmig strukturiert.

Die Begrenzungsschichten sind Material einer höheren Energiebandlücke als die Energiebandlücke der Speicherschicht, so dass die Ladungsträger, die in der Speicherschicht eingefangen sind, dort lokalisiert bleiben. Als Material für die Speicherschicht kommt vorzugsweise ein Nitrid in Frage; als umgebendes Material ist vorrangig ein Oxid geeignet. Bei einer Speicherzelle im Materialsystem von Silizium ist die Speicherschicht in dem Beispiel einer ONO-Schichtfolge Siliziumnitrid mit einer Energiebandlücke von etwa 5 eV; die umgebenden Begrenzungsschichten sind Siliziumoxid mit einer Energiebandlücke von etwa 9 eV. Die Speicherschicht kann ein anderes Material sein, dessen Energiebandlücke kleiner als die Energiebandlücke der Begrenzungsschichten ist, wobei die Differenz der Energiebandlücken für einen guten elektrischen Einschluss der Ladungsträger (confinement) möglichst groß sein soll. In Verbindung mit Siliziumoxid als Begrenzungsschichten kann z. B. Tantaloxid, Hafniumsilicat, Titanoxid (im Fall stöchiometrischer Zusammensetzung TiO₂ Zirkonoxid (im Fall stöchiometrischer Zusammensetzung ZrO₂), Aluminiumoxid (im Fall stöchiometrischer Zusammensetzung Al₂O₃) oder intrinsisch leitendes (undotiertes) Silizium als Material der Speicherschicht eingesetzt werden.

Zwischen den Kanalbereichen der Transistoren benachbarter Speicherzellen kann durch eine Implantation von Dotierstoff mit variablem Einfallswinkel eine elektrische Isolation erzeugt werden, um die Transistoren voneinander zu isolieren, eine so genannte Anti-Punch-Implantation. Eine alternative Ausgestaltung sieht vor, diese Isolation durch Aussparungen, die mit Oxid gefüllt sind, zu realisieren; das geschieht nach Art einer STI (shallow trench isolation).

In der Figur 0 ist eine Anordnung aus Wortleitungen WLₙ₋₁, WLₙ, WLₙ₊₁ und Bitleitungen BLᵢ₋₁, BLᵢ, BLᵢ₊₁ in einer Aufsicht im Schema dargestellt. Die Bitleitungen sind hier als vergrabene Bitleitungen vorhanden und mit gestrichelten Linien als verdeckte Konturen eingezeichnet. Die Wortleitungen sind als vorzugsweise metallische Leiterbahnen auf der Oberseite der Anordnung angebracht. In einer jeweiligen Kreuzungsposition eines Bitleitungszwischengebiets und einer Wortleitung ist eine Speicherzelle des Speichers angeordnet (Crosspoint-Zelle). Die jeweils auszulesende oder zu programmierende Speicherzelle wird über die Bitleitungen und Wortleitungen in der an sich bekannten Weise adressiert. Die Gesamtheit der Speicherzellen mit den dargestellten Verbindungen durch Bitleitungen und Wortleitungen bilden einen Speicher in Virtual-Ground-NOR-Architektur.

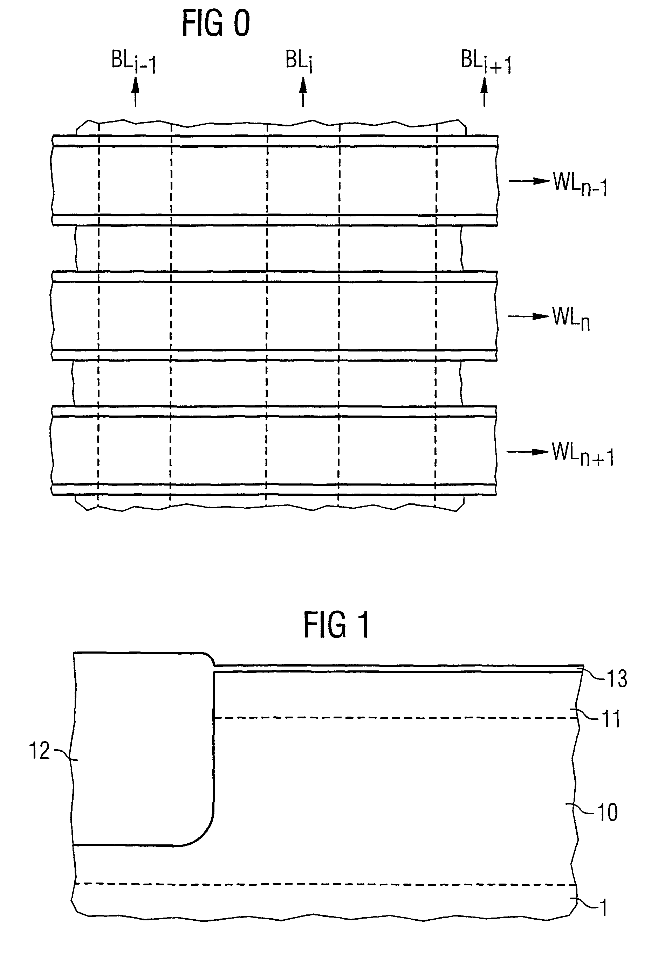

In der Figur 1 ist ein erstes Zwischenprodukt der Herstellung eines solchen Speichers in einem Querschnitt dargestellt. Es ist üblich, die Oberseite des Halbleitermateriales eines verwendeten Halbleiterkörpers 1, z. B. eines Substrates aus Silizium, oder einer auf einem Substrat aufgewachsenen Halbleiterschicht oder Halbleiterschichtfolge zunächst mit einem so genannten Pad-Oxid (Streuoxid) und Pad-Nitrid zu bedecken. Es werden Gräben in das Halbleitermaterial geätzt, die mit einem Oxid als STI (shallow trench isolation) aufgefüllt werden und zur Begrenzung des Speicherzellenfeldes (Randisolation 12) oder einzelner Speicherblöcke und gegebenenfalls zur Isolierung zwischen den Speicherzellen vorgesehen sind. Nach dem Planarisieren wird das Pad-Nitrid durch eine Ätzung entfernt. p-Wannen und n-Wannen, d. h. dotierte Bereiche, die tief in das Halbleitermaterial hinein reichen und für die Ansteuerperipherie und die Speicherzellen vorgesehen sind, werden bei Verwendung von Silizium als Halbleitermaterial vorzugsweise durch maskierte Bor-Implantationen und Phosphor-Implantationen mit anschließender Ausheilung der Implantate hergestellt. In der Figur 1 ist eine in dem Halbleiterkörper 1 ausgebildete p-Wanne 10.

Nach dem Entfernen des anfänglich aufgebrachten Pad-Oxids wird eine Oxidschicht 13 geeigneter Dicke aufgewachsen, die später außerhalb des Speicherzellenfeldes als Ätzstoppschicht dient. Bei diesem Herstellungsprozess wird dann mittels einer geeigneten Fototechnik eine Implantation (z. B. Phosphor) eingebracht, mit der ein hoch n-leitend dotierter Bereich 11 (n⁺-Bereich) in einem oberen Anteil der p-Wanne 10 ausgebildet wird, der für die später herzustellenden Source-/Drain-Bereiche vorgesehen ist. Die Vorzeichen der Dotierungen können auch vertauscht sein (p⁺-Bereich in einer n-Wanne). Im Bereich des Speicherzellenfeldes wird vorzugsweise mit derselben Fotomaske die Oxidschicht 13, die zur Ausbildung der Speicherzelle nicht erforderlich ist, nasschemisch entfernt.

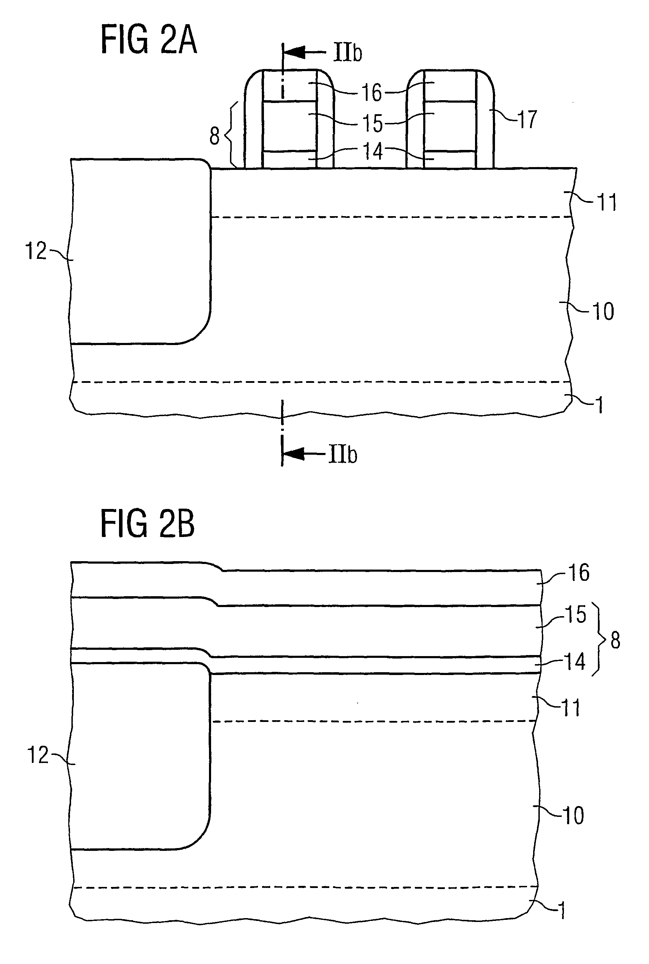

In der Figur 2a ist der in der Figur 1 dargestellte Querschnitt nach dem Aufbringen und Strukturieren einer Schichtfolge mit der streifenförmigen Bitleitung 8 wiedergegeben. Zunächst wird zur Kontaktierung der Source-/Drain-Bereiche eine Polysiliziumschicht 14 des zugehörigen Vorzeichens des Leitfähigkeitstyps aufgebracht, danach eine metallhaltige Schicht 15, beispielsweise Wolframsilicid (WSi), als eigentliche niederohmige Bitleitung und anschließend ein Material einer Hartmaske 16 (z. B. ein Oxid oder Nitrid) zur elektrischen Isolation aufgebracht. Diese Schichten werden dann vorzugsweise durch eine Fototechnik und anisotrope Ätzung streifenförmig strukturiert. Statt des WSi kann eine Schichtfolge aus Wolframnitrid und Wolfram aufgebracht werden. Die elektrisch leitende Schicht kann auch Titan und/oder Titansilicid aufweisen. Die streifenförmigen Bitleitungen 8 werden seitlich durch Spacer 17, vorzugsweise aus einem Oxid oder Nitrid, isoliert.

In der Figur 2b ist der in der Figur 2a bezeichnete Schnitt dargestellt. Es ist dort erkennbar, dass die Bitleitung 8 seitlich über die Randisolation 12 hinaus verlängert ist, so dass sie außerhalb des eigentlichen Speicherzellenfeldes kontaktiert werden kann. Der Ätzprozess zur streifenförmigen Strukturierung der Schichten wird am Rand des Zellenfeldes durch die Randisolation 12 begrenzt. Eventuell zusätzlich zu den Source-/Drain-Bereichen als dotiertes Halbleitermaterial vorhandene vergrabene Anteile der Bitleitungen enden jeweils an der Randisolation 12.

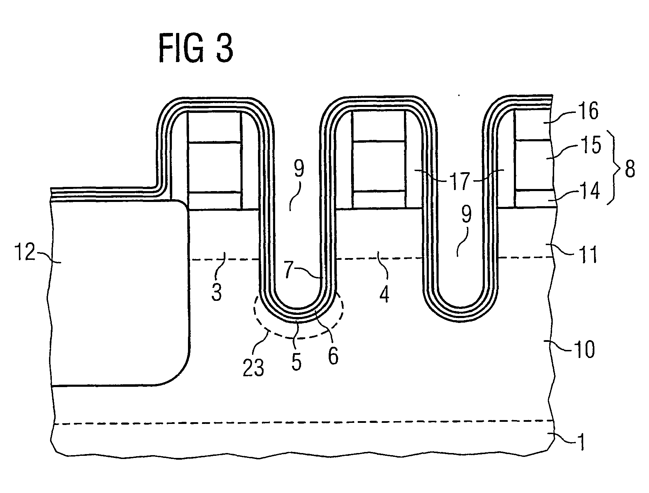

Mit den Bitleitungsstrukturen auf der Oberseite und den oxid- oder nitridbedeckten Bereichen als Maske werden, wie in der Figur 3 dargestellt, selbstjustiert Gräben 9 geätzt (z. B. mittels reactive ion etching, RIE), die für die aktiven Bereiche, insbesondere die einzelnen Speicherzellen, vorgesehen sind. Dazwischen werden die Source-/Drain-Bereiche 3, 4 ausgebildet. Außerdem ist zu berücksichtigen, dass für eine gute Funktionsweise (performance) die jeweils bei einer bestimmten Gate-Spannung vorhandene Ladungsträgerkonzentration in einem an dem Boden des Grabens vorgesehenen Anteil des Kanalbereiches des Speichertransistors ausreichend hoch sein muss; bei einer p-Wanne ist das die Elektronenkonzentration. Bei einer vorteilhaften Ausgestaltung, bei der die Wanne 10 der Speicherzelle eine typische Dotierstoffkonzentration von 10¹⁷ cm⁻³ aufweist, wird deshalb durch eine Implantation in den Boden des Grabens ein dotierter Bereich 23 ausgebildet, der die Dotierstoffkonzentration des Kanalbereiches in der Mitte stärker verändert als in den seitlichen äußeren Bereichen. Dazu wird vorzugsweise zunächst eine Opferschicht aufgebracht (z. B. sacrificial oxide, typisch etwa 6 nm dick, thermisch erzeugt). Dann wird der vorgesehene Dotierstoff implantiert; das ist in dem angegebenen Beispiel einer p-dotierten Wanne Arsen als Dotierstoff mit einer Energie von beispielsweise typisch 20 keV in einer Dosis von 10¹² cm⁻³ bis 10¹⁴ cm⁻³. Die Opferschicht wird entfernt; bei einem Oxid kann das mit verdünnter HF geschehen.

Es wird ganzflächig eine Schichtfolge aus einer unteren Begrenzungsschicht 5, einer Speicherschicht 6 und einer oberen Begrenzungsschicht 7 aufgebracht. Diese Schichtfolge ist als eigentliches Speichermedium vorgesehen und kann wie eingangs beschrieben z. B. eine an sich bekannte ONO-Schichtfolge sein. Dabei kann die untere Begrenzungsschicht 5 beispielsweise ein etwa 2,5 nm bis 8 nm dickes Oxid (bottom oxide, vorzugsweise thermisch erzeugt) sein, die Speicherschicht 6 ein etwa 1 nm bis 5 nm dickes Nitrid (vorzugsweise mittels LPCVD, low pressure chemical vapor deposition, abgeschieden) und die obere Begrenzungsschicht 7 ebenfalls ein Oxid, etwa 3 nm bis 12 nm dick.

Die damit erreichte Struktur ist in der Figur 3 im Querschnitt dargestellt. Mit geeigneter Fototechnik wird das Speicherzellenfeld abgedeckt, so dass im Bereich der Peripherie, die zum Beispiel im Rahmen eines CMOS-Prozesses hergestellt wird, die Speicherschicht einschließlich der Begrenzungsschichten entfernt werden kann. Die Speicherschicht kann auch im Bereich des Speichers auf den Böden der für die Gate-Elektroden vorgesehenen Gräben 9 und/oder zwischen den Gräben 9 entfernt werden, so dass die Speicherschicht zwischen den Wänden eines jeweiligen Grabens und/oder zwischen zwei zueinander benachbarten Gräben unterbrochen ist. Für die Ansteuerperipherie wird das Gateoxid für Hochvolttransistoren und danach eventuell ein dünneres Gateoxid für Niedervolttransistoren aufgewachsen. Mit weiteren Masken und Implantationen können die Einsatzspannungen eingestellt werden.

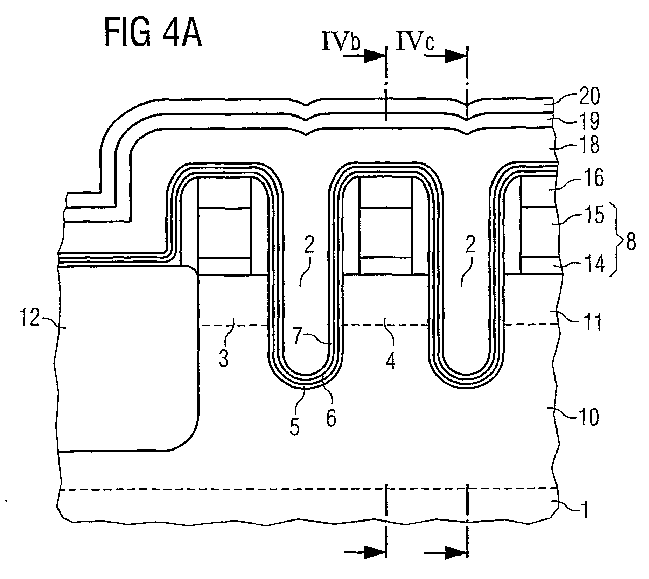

In dem in der Figur 4a dargestellten Querschnitt ist die Struktur nach dem Abscheiden einer für die Gate-Elektroden 2 vorgesehenen leitend dotierten Polysiliziumschicht 18 sowie einer für die Wortleitung vorgesehenen metallhaltigen Schicht 19 (hier WSi) und einer Hartmaskenschicht 20 dargestellt. Das Polysilizium wird in einer Dicke von typisch 80 nm abgeschieden und vorzugsweise in situ dotiert und ist für die Gate-Elektroden vorgesehen. Die eigentlichen Wortleitungen werden durch das niederohmige, metallische oder metallhaltige Material der metallhaltigen Schicht 19 gebildet. Statt Wolframsilicid kann ein Silicid eines anderen Metalles oder eine mehrlagige metallhaltige Schicht vorhanden sein. Das Material der Hartmaskenschicht 20 ist z. B. ein verdichtetes Oxid.

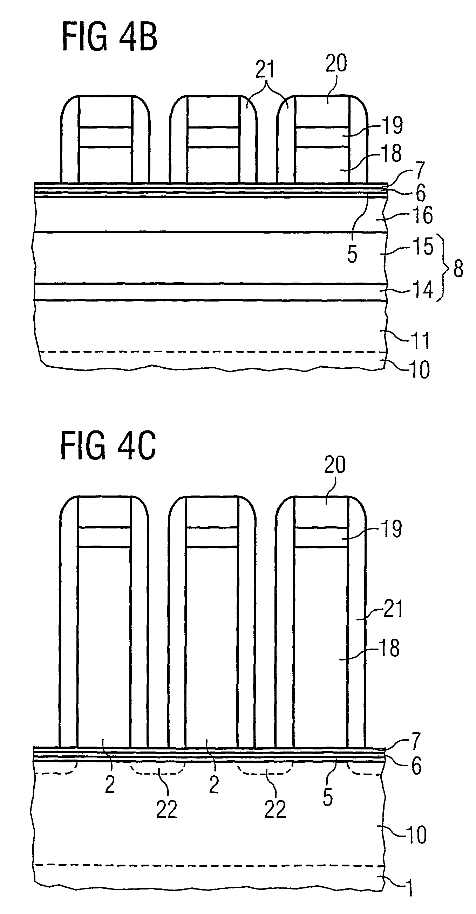

In der Figur 4b und der Figur 4c sind die in der Figur 4a eingezeichneten Schnittansichten dargestellt. In dem Querschnitt der Figur 4b befindet sich die Schichtfolge der Speicherschicht 6 zwischen den Begrenzungsschichten 5, 7 oberhalb der Bitleitung 8, die in diesem Beispiel aus der Polysiliziumschicht 14 und der metallhaltigen Schicht 15 gebildet ist, und davon isoliert durch die Hartmaske 16. In der Figur 4c ist ein Schnitt durch die Gate-Elektroden 2 zwischen zwei Bitleitungen dargestellt, wo die Speicherschicht 6 am Boden der für die Gate-Elektroden vorgesehenen Gräben verläuft. Die aufgebrachte Schichtfolge aus der Polysiliziumschicht 18, der metallhaltigen Schicht 19 und der Hartmaskenschicht 20 wird, wie in den Figuren 4b und 4c zu erkennen ist, streifenförmig strukturiert, so dass quer zu den Bitleitungen verlaufende Wortleitungen ausgebildet werden. Die Flanken der Wortleitungen sind durch Spacer 21 isoliert. Die Spacer werden in der an sich bekannten Weise dadurch ausgebildet, dass eine aus dem Material der Spacer bestehende Schicht isotrop ganzflächig aufgebracht und anisotrop so rückgeätzt wird, dass im Wesentlichen nur die hohen vertikalen Anteile der Spacer 21 an den Flanken der streifenförmig geätzten Wortleitungen stehen bleiben. Die Zwischenräume zwischen den Gate-Elektroden unterhalb der Wortleitungen können statt dessen ganz oder teilweise mit dem Material der Spacer gefüllt bleiben.

In diesem Verfahrensschritt können gleichzeitig die Gate-Elektroden der Transistoren der Ansteuerperipherie strukturiert werden. Im Bereich des Speicherzellenfeldes stoppt die Ätzung der Gate-Elektroden auf der oberen Begrenzungsschicht 7 bzw. der ONO-Schichtfolge. Es kann ergänzend eine Gate-Reoxidation erfolgen und je nach Bedarf eine Anti-Punch-Implantation 22 zur Isolation benachbarter Transistoren eingebracht werden.

Weitere übliche und an sich bekannte Verfahrensschritte zur Herstellung der Transistoren können gleichermaßen vorgesehen werden, wie z. B. LDD-Implantationen (lightly doped drain) und HDD-Implantationen oder eine Abscheidung einer Passivierung aus Nitrid und einer Planarisierung mittels BPSG (Borphosphorsilicatglas) und CMP. Weitere Schritte zur Vervollständigung bestehen in der Herstellung und Füllung von Kontaktlöchern (via holes) sowie der Herstellung von Metallisierungen und Passivierungen. Diese Herstellungsschritte sind von der Herstellung von Speicherbauelementen an sich bekannt.

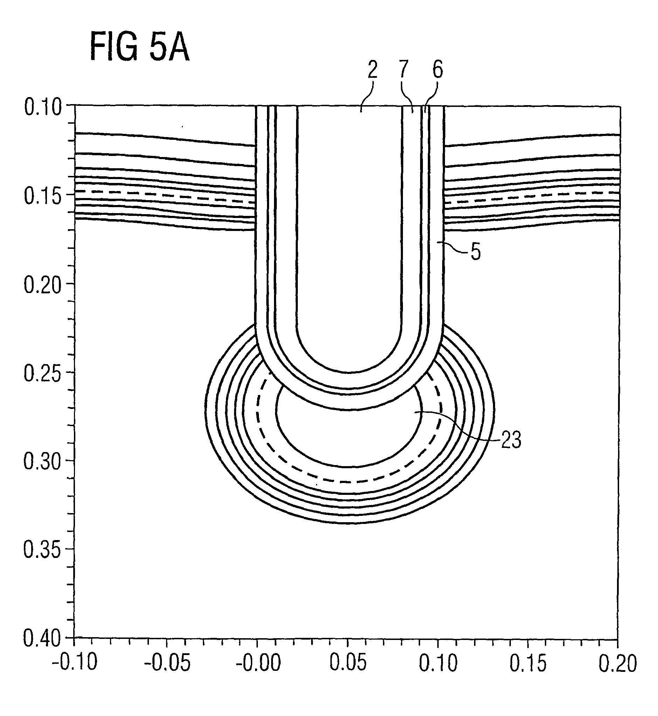

In der Figur 5a ist ein Diagramm zu einer Modellrechnung dargestellt, in dem auf der Abszisse die laterale Abmessung in der Zeichenebene der Figur 3 und auf der Ordinate der Abstand d von der Oberseite des Halbleiterkörpers oder einer bestimmten Schichtlage innerhalb des Halbleiterkörpers in µm abgetragen ist. Es sind im Bereich des Halbleitermaterials des Grabenbodens Linien gleicher Dotierstoffkonzentration für ein typisches Ausführungsbeispiel des dotierten Bereiches 23 eingetragen.

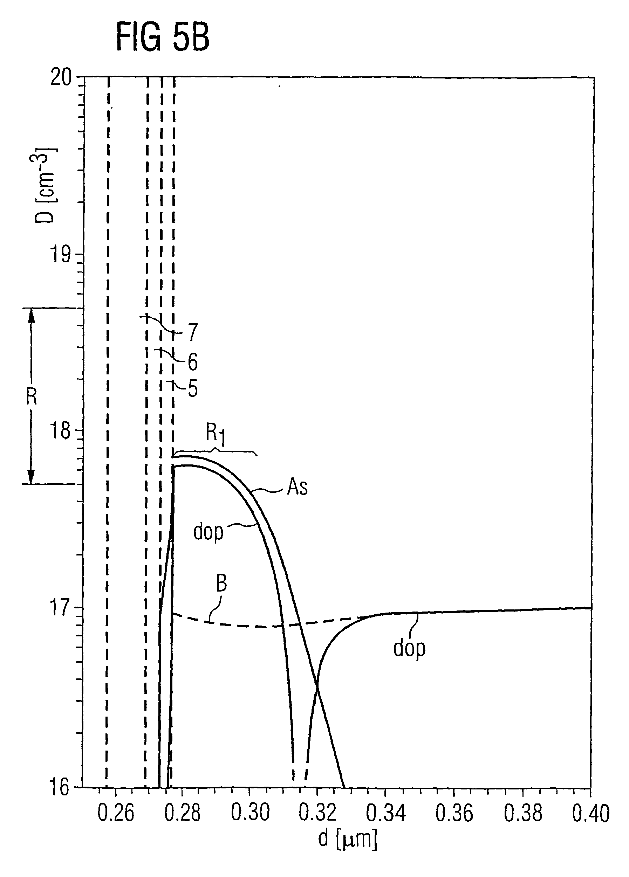

In der zugehörigen Figur 5b ist auf der Abszisse der jeweilige Ordinatenwert d/µm aus Figur 5a übertragen. Auf der Ordinate ist die Dotierstoffkonzentration D in cm⁻³ (Anzahl Dotierstoffatome pro Kubikzentimeter) aufgetragen. Die senkrechten gestrichelten Linien markieren die Grenzen zwischen den Begrenzungsschichten 5, 7 und der Speicherschicht 6. Die Graphen für die Dotierstoffkonzentrationen von Arsen und Bor sind durchgezogen bzw. gestrichelt eingetragen. Die Borkonzentration ist in diesem Beispiel konstant 10¹⁷ cm⁻³, idealerweise konstant bei 2·10¹⁷ cm⁻³, kann auch 3·10¹⁷cm⁻³ betragen; sie wird allerdings durch Diffusion von Boratomen in das Dielektrikum der Begrenzungsschicht 5 im Bereich des Abszissenwertes um etwa 0,3 µm etwas abgeschwächt. Unterhalb der unteren Begrenzungsschicht 5 wird bei den bevorzugten Ausführungsbeispielen in einem Bereich unterhalb der tiefsten Stelle des Grabenbodens, der bis 20 nm tief in das Halbleitermaterial hinein reicht, (Abmessung R₁ in der Figur 5b) eine Dotierstoffkonzentration des Arsens von 5·10¹⁷ cm⁻³ bis 5·10¹⁸ cm⁻³ eingestellt. Das kann insbesondere durch eine Arsenimplantation mit einer Dosis von typisch etwa 2·10¹² cm⁻² bei einer Energie von 20 keV geschehen (wie bereits oben angegeben unter Verwendung eines anschließend zu entfernenden Streuoxids von etwa 6 nm Dicke). Der Bereich R der so eingestellten Dotierstoffkonzentrationen ist in der Figur 5b an der Ordinate markiert.

Bei einer um einen bestimmten Faktor höheren Borkonzentration als Grunddotierung des Halbleitermateriales oder als Wannendotierung sind die angegebenen Grenzen für die Arsenkonzentration mit diesem Faktor zu multiplizieren. Es wird so in demjenigen Teil des dotierten Bereiches 23, der sich an dem am weitesten in das Halbleitermaterial hineinragenden Anteil in der Mitte des Bodens des Grabens befindet und 20 nm vertikal bezüglich des Bodens des Grabens in das Halbleitermaterial hinein reicht, eine Dotierstoffkonzentration eingestellt, deren Wert in einem Bereich liegt, dessen Grenzen durch 5·10¹⁷ cm⁻³ und 5·10¹⁸ cm⁻³, jeweils multipliziert mit einem Quotienten aus einer Konzentration eines Dotierstoffes, der in diesem Bereich als Grunddotierung oder Wannendotierung in das Halbleitermaterial eingebracht ist, gemessen in cm⁻³, und dem Wert 10¹⁷ cm⁻³, bestimmt sind. Als Dotierstoffe kommen auch andere als die angegebenen in Frage unter der Maßgabe, dass die damit erzeugten Leitfähigkeitstypen das jeweils passende Vorzeichen besitzen.

Die von der Speicherzellenanordnung beanspruchte Fläche lässt sich dadurch verkleinern, dass auf eine elektrische Isolation zwischen den Zellen, z. B. durch STI (Shallow Trench Isolation), innerhalb des Zellenfeldes verzichtet wird. Problematisch bei fortgesetzter Verkleinerung der Strukturgröße ist jedoch die elektrische Trennung der einzelnen Speicherzellen an zueinander benachbarten Wortleitungen. Insbesondere die dotierten Bereiche 23 zur Einstellung der Ladungsträgerkonzentration im Kanalbereich an den Böden der Gräben 9 sind die Ursache für eine elektrisch leitende Verbindung im Substrat oder zumindest für unerwünschtes Übersprechen zwischen zueinander benachbarten Reihen von Speicherzellen. Eine Isolationsimplantierung zwischen den Wortleitungen scheint nicht geeignet zu sein, dieses Übersprechen wirkungsvoll zu beseitigen.

Aufgabe der vorliegenden Erfindung ist es, anzugeben, wie bei der eingangs beschriebenen Speicherzellenanordnung ein Übersprechen zwischen benachbarten Reihen von Speicherzellen verhindert werden kann.

Diese Aufgabe wird mit dem Verfahren zur Herstellung eines NROM-Speicherzellenfeldes mit den Merkmalen des Anspruchs 1 gelöst. Ausgestaltungen ergeben sich aus den abhängigen Ansprüchen.

Bei dem Verfahren wird das Halbleitermaterial an den Böden der Gräben im Bereich zwischen den Wortleitungen soweit weggeätzt, dass die dotierten Bereiche dort ganz oder zumindest so weitgehend entfernt werden, dass ein Übersprechen zwischen längs der Gräben benachbarten Speichenzellen in vorgesehenem Umfang reduziert wird. Vorzugsweise werden die dotierten Bereiche an den Grabenböden zwischen den Wortleitungen vollständig weggeätzt. Bei bestimmten Ausführungsformen kann es jedoch genügen, zumindest den mittleren Bereich hoher Dotierstoffkonzentrationen im unteren Teil der Gräben zu entfernen.

Es folgt eine genauere Beschreibung eines typischen Beispiels des Verfahrens anhand der beigefügten Figuren.

Die Figur 0 zeigt eine schematische Anordnung der Wortleitungen und Bitleitungen in Aufsicht.

Die Figuren 1, 2a, 2b, 3, 4a, 4b und 4c zeigen Querschnitte durch Zwischenprodukte nach verschiedenen Schritten eines bevorzugten Herstellungsverfahrens.

Die Figuren 5a und 5b zeigen Diagramme zu Modellrechnungen.

Die Figur 6 zeigt eine schräge Schnittansicht nach der Herstellung der Wortleitungen.

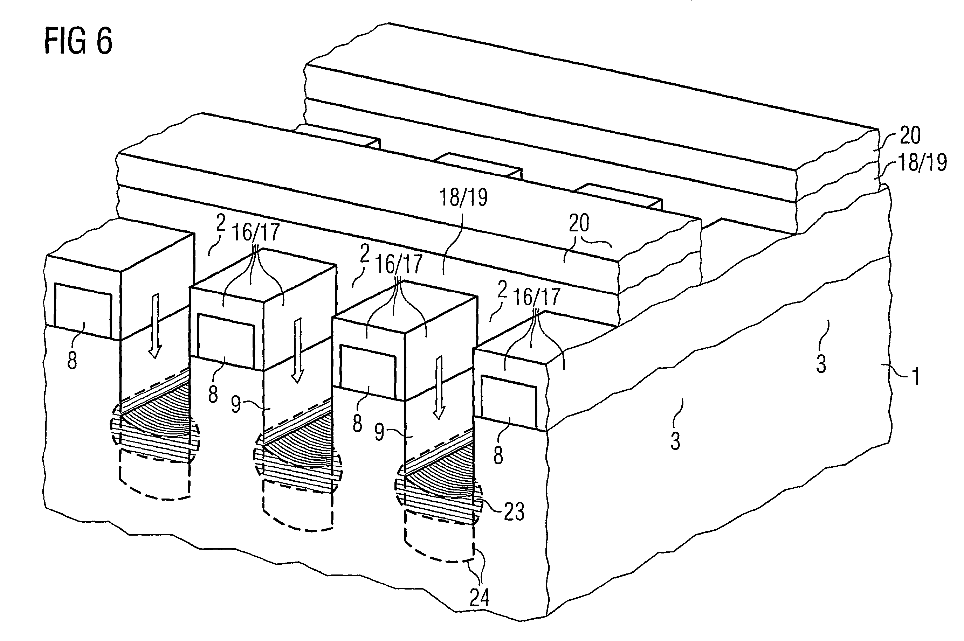

In der Figur 6 ist in einer schrägen Aufsicht ein Zwischenprodukt des Herstellungsverfahrens gezeigt, das nach dem Herstellen der Wortleitungen erhalten wird. Das Verfahren umfasst dabei alle alternativen Ausgestaltungen, die zu der prinzipiellen Struktur gemäß Figur 6 führen. Wesentlich ist dabei nur, dass zwischen den Gräben, die für die Speichertransistoren vorgesehen sind, die Source-/Drain-Bereiche in dem Halbleitermaterial ausgebildet und mit auf der Oberseite des Halbleitermaterials angeordneten Bitleitungen 8 verbunden sind. Diese Bitleitungen 8 sind mit elektrisch isolierendem Material einer Abdeckschicht 16/17, z. B. einer bei der Herstellung auf der Oberseite aufgebrachten Hartmaske und seitlich angeordneten Spacern, gegen das Material der Wortleitungen 18/19 elektrisch isoliert. Das Material der Wortleitungen bildet innerhalb der Gräben 9 die Gate-Elektroden 2 der Speichertransistoren. Auf der Oberseite der Wortleitungen ist z. B. eine Hartmaskenschicht 20 vorhanden, die auch zur streifenförmigen Strukturierung der Wortleitungen 18/19 verwendet worden ist. Wie der Darstellung zu entnehmen ist, wurde bei dem Verfahren auf eine elektrische Isolation zwischen den Wortleitungen, z. B. durch STI-Isolationsgräben, verzichtet. Zwischen den Gate-Elektroden 2 sind daher die Gräben 9 offen.

An den Böden der Gräben befinden sich die dotierten Bereiche 23, die für eine Einstellung der Ladungsträgerkonzentration im Kanalbereich vorgesehen sind. Zur Kenntlichmachung der dotierten Bereiche 23 wurden diese Bereiche in der Figur 6 jeweils mit Schraffuren eingezeichnet. Dabei handelt es sich jedoch nur in der vorderen Aufsicht um eine Schnittfläche, während die übrigen schraffierten Flächen die Böden der Gräben und die untersten Anteile der Grabenwände darstellen. Um die elektrische Isolation zwischen den zueinander benachbarten Speicherzellen in der Richtung der Bitleitungen 8 zu verbessern, werden ausgehend von der dargestellten Struktur zwischen den Wortleitungen in der Richtung der eingezeichneten Pfeile Aussparungen in das Halbleitermaterial der Grabenböden geätzt, so dass die ausgeätzten Bereiche 24 gebildet werden. Je nach der seitlichen Abmessung der dotieren Bereiche 23 können die dotierten Bereiche 23 bei dem Ätzprozess vollständig oder nur in wesentlichem Umfang entfernt werden. Die in der Zeichnung dargestellten seitlichen Anteile der dotierten Bereiche 23 werden z. B. entfernt, wenn die durchgeführte Ätzung im Bereich des Grabenbodens den ausgeätzten Bereich seitlich aufweitet. In der schematisierten Darstellung der Figur 6 ist eine streng anisotrope Ätzung in der Richtung der angezeichneten Pfeile angenommen. Die ausgeätzten Bereiche 24 können je nach Prozessführung jedoch seitlich so aufgeweitet werden, dass auch die seitlichen Anteile der dotierten Bereiche 23 vollständig entfernt werden.

Je nach der Art des Dotierstoffprofils in den dotierten Bereichen 23 kann es auch genügen, eine geringere als die in der Figur 6 dargestellte Ätztiefe einzustellen. Ein typischer Wert für die Ätztiefe, um die der Grabenboden zwischen den Wortleitungen abgesenkt wird, beträgt etwa 80 nm. Die Ätzung erfolgt in selbstjustierter Weise, so dass keine weitere Maske und kein zusätzlicher Lithographieschritt erforderlich sind. Die Wortleitungen und die elektrischen Isolationen auf der Oberseite der Bitleitungen 8 (vorzugsweise Nitrid) dienen bei dem Ätzschritt als Maske. Eine Abdeckschicht aus Nitrid auf der Oberseite der Bitleitungen 8 (z. B. die Hartmaske 16) wird typisch in einer Dicke von 100 nm hergestellt.

### Bezugszeichenliste

- 1: Halbleiterkörper
- 2: Gate-Elektrode
- 3: Source-/Drain-Bereich
- 4: Source-/Drain-Bereich
- 5: Begrenzungsschicht
- 6: Speicherschicht
- 7: Begrenzungsschicht
- 8: Bitleitung
- 9: Graben
- 10: p-Wanne
- 11: dotierter Bereich
- 12: Randisolation
- 13: Oxidschicht
- 14: Polysiliziumschicht
- 15: metallhaltige Schicht
- 16: Hartmaske
- 17: Spacer
- 18: Polysiliziumschicht
- 19: metallhaltige Schicht
- 20: Hartmaskenschicht
- 21: Spacer
- 22: Anti-Punch-Implantation
- 23: Anteil des Kanalbereiches
- 24: ausgeätzter Bereich

## Patentansprüche

1. Verfahren zur Herstellung eines NROM-Speicherzellenfeldes, bei dem
an einer Oberseite eines Halbleiterkörpers (1) oder einer Halbleiterschicht eine Implantation von Dotierstoff zur Ausbildung von Source-/Drain-Bereichen (3, 4) eingebracht wird, parallel im Abstand zueinander angeordnete Gräben (9) in das Halbleitermaterial geätzt werden und zwischen diesen Gräben (9) auf der Oberseite des Halbleiterkörpers (1) oder der Halbleiterschicht jeweils eine parallel zu den Gräben (9) verlaufende Bitleitung (8) angeordnet wird, die mit den zwischen den betreffenden Gräben (9) vorhandenen Source-/Drain-Bereichen (3, 4) elektrisch leitend verbunden ist und oberseitig mit einer Abdeckschicht (16/17) zur elektrischen Isolation versehen wird, in das Halbleitermaterial an den Böden der Gräben (9) jeweils eine Implantation von Dotierstoff zur Ausbildung eines dotierten Bereichs (23), der die elektrischen Eigenschaften eines dort vorgesehenen Kanalbereiches modifiziert, eingebracht wird, zumindest an den Wänden der Gräben (9) eine Speicherschicht (5, 6, 7) aufgebracht wird, in vorgesehenen Abständen Gate-Elektroden (2) in den Gräben angeordnet werden und diese Gate-Elektroden (2) mit quer zu der Richtung der Bitleitungen (8) verlaufend aufgebrachten Wortleitungen (18/19) elektrisch leitend verbunden werden,
**dadurch gekennzeichnet, dass**
die dotierten Bereiche (23) in Bereichen zwischen den Wortleitungen (18/19) zumindest teilweise entfernt werden, indem das betreffende Halbleitermaterial an den Böden der Gräben (9) weggeätzt wird.

2. Verfahren nach Anspruch 1, bei dem
die Böden der Gräben (9) zwischen den Wortleitungen (18/19) um mindestens 80 nm tiefer geätzt werden.

3. Verfahren nach Anspruch 1 oder 2, bei dem
als Abdeckschicht (16/17) Nitrid auf die Bitleitungen (8) aufgebracht wird und
diese Nitridschicht als Maske beim Ätzen der Gräben verwendet wird.

## Claims

1. Method for fabricating an NROM memory cell array, in which,
at a top side of a semiconductor body (1) or of a semiconductor layer, an implantation of dopant is introduced in order to form source/drain regions (3, 4), trenches (9) arranged parallel at a distance from one another are etched into the semiconductor material and a bit line (8) running parallel to the trenches (9) is in each case arranged between said trenches (9) on the top side of the semiconductor body (1) or of the semiconductor layer, which bit line is electrically conductively connected to the source/drain regions (3, 4) present between the relevant trenches (9) and, on the top side, is provided with a covering layer (16/17) for electrical insulation, an implantation of dopant is in each case introduced into the semiconductor material at the bottoms of the trenches (9) in order to form a doped region (23), which modifies the electrical properties of a channel region provided there, a storage layer (5, 6, 7) is applied at least at the walls of the trenches (9), gate electrodes (2) are arranged in the trenches at predetermined distances and said gate electrodes (2) are electrically conductively connected to word lines (18/19) applied in a manner such that they run transversely with respect to the direction of the bit lines (8),
**characterized in that**,
the doped regions (23), in regions between the word lines (18/19), are at least partially removed by etching away the relevant semiconductor material at the bottoms of the trenches (9).

2. Method according to Claim 1, in which
the bottoms of the trenches (9) are etched more deeply by at least 80 nm between the word lines (18/19).

3. Method according to Claim 1 or 2, in which
nitride is applied to the bit lines (8) as covering layer (16/17), and
said nitride layer is used as a mask during the etching of the trenches.

## Revendications

1. Procédé de production d'un champ de cellules de mémoire NROM, dans lequel
on introduit, sur un côté supérieur d'un corps (1) semi-conducteur ou d'une couche semi-conductrice, une implantation de substance de dopage pour former des zones (3, 4) de source/drain, on ménage par attaque parallèlement des sillons (9) disposés à distance les uns des autres dans le matériau semi-conducteur et on dispose entre ces sillons (9), du côté supérieur du corps (1) semi-conducteur ou de la couche semi-conductrice, respectivement une ligne (8) de bits s'étendant parallèlement aux sillons (9) et reliée d'une manière conductrice de l'électricité à des zones de source/drain présentes entre les sillons (9) concernés et, du côté supérieur, on le munit d'une couche (16,/17) de finition pour l'isolement électrique, on introduit dans le matériau semi-conducteur, sur les fonds des sillons (9), respectivement une implantation de substance de dopage pour la formation d'une zone (23) dopée qui modifie les propriétés électriques d'une zone de canal qui y est prévue, on dépose une couche (5, 6, 7) d'emmagasinage au moins sur les parois des sillons (9), on dispose dans les sillons des électrodes (2) de grille à des distances prévues à l'avance et on relie ces électrodes (2) de grille d'une manière conductrice de l'électricité à des lignes (18/19) de mots déposées en s'étendant transversalement à la direction des lignes (8) de bits,
**caractérisé en ce qu'**on élimine au moins en partie les zones (23) dopées dans les zones comprises entre les lignes (18/19) de mots, en enlevant par attaque le matériau semi-conducteur concerné sur les fonds des sillons (9).

2. Procédé suivant la revendication 1, dans lequel on attaque plus profondément d'au moins 80 nm les fonds des sillons (9) entre les lignes (18/19) de mots.

3. Procédé suivant la revendication 1 ou 2, dans lequel on dépose, comme couche (16/17) de finition, du nitrure sur les lignes (8) de bits et
on utilise cette couche de nitrure comme masque lors de l'attaque des sillons.
